# EUROPEAN PATENT APPLICATION

(11) **EP 0 851 552 A1**
(43) Date of publication of application: **01.07.1998**
(21) Application number: 96830664.7
(22) Date of filing: 31.12.1996
(51) Int. Cl.: H02H 1/00, H02H 9/04

(54) **Protection ciruit for an electric supply line in a semiconductor integrated device**

(71) Applicant: SGS-THOMSON MICROELECTRONICS s.r.l., 20041 Agrate Brianza (Milano) (IT)
(72) Inventor: Ravanelli, Enrico M.A., 20052 Monza (MI) (IT); Fontanella, 20100 Milano (IT)

(57) **Abstract**

A protection circuit for a power supply line (Vdd) in a semiconductor device, comprising first (M1) and second (M2) field-effect transistors, both having their respective drain terminals connected to the power supply line (Vdd).

The gate and source terminals of the first transistor (M1) are connected to ground (GND) through first (R1) and second (R2) resistors, respectively.

The gate and source terminals of the second transistor (M2) are connected to the source terminal of the first transistor (M1) and to ground (GND), respectively.

## Description

This invention relates to protection elements or circuits for the terminals of an integrated circuit whereto they are incorporated, and in particular to a protection circuit for a power supply terminal or line of an integrated circuit device.

In fact, MOS technology integrated circuits, and the low-voltage supplied portions of devices integrated with mixed-type technologies, such as logic circuits included in such devices, can suffer serious damage from electrostatic discharges (ESD) generally at their terminals.

In addition, malfunction or damage may result from the application of overvoltages to their supply terminals.

In the respect of electrostatic discharges, it is a recognized fact that the terminals of an integrated circuit are open to incidentally come in contact with electrically charged objects, both during their fabrication and their inclusion to a circuit assembly, or in operation, whereby differences of potential of substantial magnitude may be established, for example, between the gate electrodes of input transistors, or the drain regions of output transistors, and the semiconductor material substrate on which the integrated circuit is formed. In the former case, when the difference of potential exceeds the threshold dielectric strength of the gate insulator, the transistor is put out of use by the electrostatic discharge which develops through the insulation, while in the latter case, a similar destructive effect is incurred when the difference of potential exceeds the reverse breakdown threshold of the drain junction. Also as an example, in a CMOS integrated circuit fabricated with 1.2 µm technology (i.e., with a minimum gate dimension of 1.2 µm), the breakdown voltage is of 12 to 14 volts for the input transistors, and of about 12 volts for the output transistors.

Several measures have been proposed for protecting the various input, output, and supply terminals from electrostatic discharges.

In many cases, protection devices have been successfully employed which utilize bipolar side transistors.

A known protector, eminently suitable for monolithic integration to a CMOS integrated circuit requiring protection, is disclosed in Italian Patent Application No. 26063 A/80 by this Applicant, for example.

That device is basically comprised of an NPN side transistor whose emitter and collector are doped with impurities of the N type, similarly and simultaneously with the source and drain regions of the IGFETs of the MOS circuit to be protected, and whose unaccessible base is heavily and deeply doped with ion acceptors (impurities of the P type) by ion implantation.

In Italian Patent Application No. 23077 A/85 by the Applicant, there is disclosed an improved use of the same structure. The protector comprises first and second bipolar side transistors having their collector terminals respectively connected to the input terminal of the circuit and the gate electrodes of the IGFETs, and having their emitter terminals jointly connected to a ground terminal, and a diffused resistor (R') connecting together the collectors of the two side transistors.

The width of the first transistor base and the concentration of impurities in the bases of both side transistors are effective to keep the voltage which would trigger the appearance of negative resistance in the first side transistor, and the breakdown voltage in the second side transistor, at a value below the breakdown voltage of the gate isolating oxides and below the breakdown voltage of the bipolar junctions contained in the integrated circuit, and effective to keep the sustaining voltage of the first side transistor at a value above the supply voltage to the integrated circuit.

A simple, yet effective known protector from electrostatic discharges may be a bipolar transistor with shorted base and emitter, connected between the terminal to be protected and ground.

The transistor would then have a current/voltage characteristic of the bistable type between a high impedance, high voltage state, referred to as BVcbo in the art and a low impedance, low voltage state, referred to as BVcer.

The transistor would operate in the first mode during normal operation of the circuit, and leave it unconcerned; but on the occurrence of an electrostatic discharge, the transistor would be forced to operate in the second mode, thereby opening a way to ground for the discharge pulse.

The effectiveness of such protective measures using bipolar transistors dwindles considerably where a supply line or terminal is to be protected. In fact, BVcbo and BVcer may have statistic process variations which result in their effective values being inconsistent with the circuit operation requirements in the instance of a line or terminal being at the highest potential provided in the integrated circuit.

Moreover, voltage noise on the supply line to be protected could turn on the bipolar transistor protector and cause the supply voltage to be clamped to BVcer, that is to a far lower value than that intended for powering the circuit.

This may result not only in circuit malfunction, but also in permanent damage, due to a large direct current being then flowed through the circuit.

The technical problem that underlies this invention is to provide a protection circuit which can be used to advantage for protecting a power supply line or terminal in an integrated circuit device from electrostatic discharges.

This technical problem is solved by a protection circuit as indicated above and defined in the characterizing portions of the appended claims to this specification.

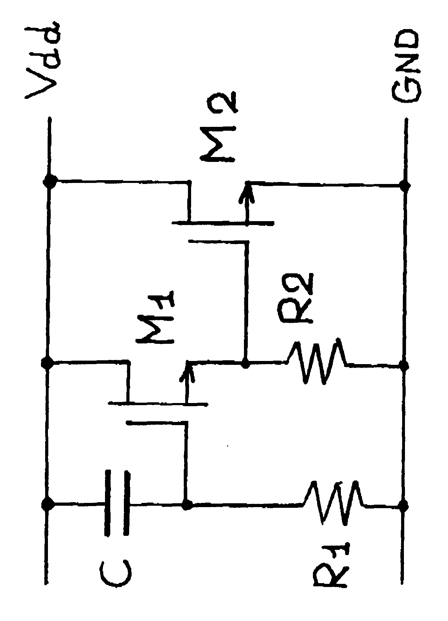

The features and advantages of a protection circuit according to the invention will be apparent from the following description of an embodiment thereof, given by way of non-limitative example with reference to the accompanying drawing.

The single drawing figure is a diagram of a protection circuit according to the invention and intended for a power supply line or terminal of an integrated circuit device.

A protection circuit according to this invention, of which a diagram is shown in the drawing, comprises a first field-effect transistor M1 having its gate and source terminals connected to ground at GND, respectively through first and second resistors, R1 and R2, and its drain terminal connected to the power supply line Vdd to be protected.

The circuit comprises a second field-effect transistor M2, connected between ground and the supply line through its source and drain terminals, respectively, and having its gate terminal connected to the source terminal of the transistor M1.

Also shown in the drawing is a capacitor C which is connected between the gate terminal and the drain terminal of the transistor M1. For optimum performance, the use of a true monolithically integrated capacitor would seem an expedient choice, but the protector effectiveness may be ensured already by the intrinsic capacitance that exists between the source and the drain of the transistor M1 itself. The resistors may be diffused or polycrystalline silicon ones.

A protection circuit according to the invention is a dynamic circuit which is only activated by a transient condition, and reveals no harmful latchup proneness.

All its components operate in the active zone during the protection function, unlike the aforementioned conventional devices which operate in an avalanche conduction mode.

The use of components of the VDMOS type is highly advantageous in that they are sure to inhibit the overtaking of voltages set by the integration process, during the electrostatic discharge.

The minimum variation level dV/dt of the supply voltage for activation of the protector should be greater than,
2 Vth/R1 C,
where, Vth is the threshold voltage of transistor M1; under a condition of DC current, no current will flow through the protection circuit.

The channel region of the output transistor M2 should be suitably dimensioned to have the operation of the driver transistor M1 held within the triode range.

In that case, the drain-gate voltage at the transistor M2 would be quite low, and the transistor held at the fringe of the saturation range.

Thus, there can occur permanent snapback and latchup for neither transistors.

A protection circuit according to the invention is quite fast, the turn-on time of the VDMOS components being given as,
L/Vsat
where, L is the length of the channel, and vsat is the speed of the saturating electrons.

This turn-on is normally much faster than the leading edges of the ESD pulses, and the circuit can effectively suppress all frequency components.

The clamping voltage of the protector is not much higher than the gate-source voltage of the transistor M1 in saturation, and accordingly, this protection circuit shows improved effectiveness upon the prior art protectors during the electrostatic discharge.

A protection circuit according to this invention would be unaffected by "spreads" in the integration process and consistent with the requirement for high process voltages.

By appropriate dimensioning of the transistors, the triggering voltage can be easily varied between 5 and 60 volts.

Furthermore, a protection circuit according to the invention would be highly effective to avoid damaging the device whenever a supply line is applied a higher voltage than the supply rating, even if such a circumstance is a durable one.

It should be understood that modifications or substitutions may be made unto the embodiment described hereinabove, in ways known to the skilled ones.

## Claims

1. A protection circuit for a power supply line (Vdd) in a monolithically integrated semiconductor device, characterized in that it comprises first (M1) and second (M2) field-effect transistors, each having first and second terminals and a control terminal, the control terminal and the first terminal of the first transistor (M1) being connected to a ground (GND) through first (R1) and second (R2) resistive elements, respectively, the first terminal and the control terminal of the second transistor (M2) being respectively connected to the ground (GND) and the first terminal of the first transistor (M1), and the second terminal of each of the two transistors being connected to said power supply line (Vdd).

2. A protection circuit according to Claim 1, characterized in that the control terminal of the first transistor is connected to the power supply line (Vdd) through a capacitive element (C).

3. A protection circuit according to any of the preceding claims, characterized in that the first (M1) and second (M2) field-effect transistors are of the VDMOS type and have their respective drain terminals connected to the power supply line (Vdd).
